# EUROPÄISCHE PATENTANMELDUNG

(11) **EP 3 690 934 A1**
(43) Veröffentlichungstag der Anmeldung: **05.08.2020**
(21) Anmeldenummer: 19155237.1
(22) Anmeldetag: 04.02.2019
(51) Int. Cl.: H01L 23/367, H01L 23/467, H05K 1/02

(54) **ENTWÄRMUNG EINER ELEKTRONISCHEN BAUGRUPPE MITTELS FORCIERTER KONVEKTION, SOWIE VERFAHREN ZUM ENTWÄRMEN EINER ELEKTRONISCHEN BAUGRUPPE**

(71) Anmelder: Siemens Aktiengesellschaft, 80333 München (DE)
(72) Erfinder: Diepold, Fabian, 93336 Altmannstein (DE); Kiesel, Alexander, 91054 Erlangen (DE); Weis, Benno, 91334 Hemhofen (DE); Fürst, Johannes, 92348 Stöckelsberg (DE)

(57) **Zusammenfassung**

Die Erfindung betrifft eine elektronische Baugruppe (1) mit,
- einer Leiterplatte (2), welche mit einer ersten Bestückungsseite (3) und einer zweiten Bestückungsseite (4) ausgebildet ist,
- zumindest einem ersten Kühlkörper (5), welcher auf der ersten Bestückungsseite (3) angeordnet ist,
- mehreren elektronischen Bauelementen (6), von denen eine Mehrzahl auf der zweiten Bestückungsseite (4) der Leiterplatte (2) angeordnet ist,
- zumindest einer ersten nicht stromführenden Durchkontaktierung (7) in der Leiterplatte (2), mit welcher eine erzeugte thermische Energie eines elektronischen Bauelements (6) von der zweiten Bestückungsseite (4) zu der ersten Bestückungsseite (3) transportierbar ist, und
- einer Konvektionseinheit (8) zum Erzeugen einer forcierten Konvektion (9) ausschließlich auf der ersten Bestückungsseite (3), mit welcher die thermische Energie von der Leiterplatte (2) der elektronischen Baugruppe (1) abtransportierbar ist, sodass eine Entwärmung der elektronischen Baugruppe (1) durchführbar ist. Des Weiteren betrifft die Erfindung ein Verfahren zum Entwärmen einer elektronischen Baugruppe (1).

## Beschreibung

Die Erfindung betrifft eine elektronische Baugruppe sowie ein Verfahren zum Entwärmen einer elektronischen Baugruppe.

Heutige Frequenzumrichter werden mit standard Silizium-IGBT-Modulen gebaut. Neuartige Leistungshalbleiter, zum Beispiel Gallium-Nitrid (GaN) mit großem Bandabstand, sind meist als diskrete Bauelemente verfügbar. Eines der Hauptprobleme ist dabei die Entwärmung der Schalt- und Durchlassverluste. Die Schaltverluste sind beim harten Schalten besonders hoch, wodurch sowohl die Schaltfrequenz, als auch der Durchlassstrom, abhängig von der Schaltertechnik thermisch begrenzt wird. Damit einhergehend steigt die Notwendigkeit der gekonnten Entwärmung der Leistungshalbleiter. Im Gegensatz zu heutigen Leistungsmodulen handelt es sich bei diesem neuartigen Bauelement meist um diskrete Schalter, die auf einem Trägermaterial aufgelötet werden.

Diese neuartigen Leistungshalbleiterschalter, insbesondere GaN-Schalter, werden oft als Surface Mounted Device(SMD)-Bauelement angeboten, wobei die elektrischen Anschlüsse nur auf einer Seite ausgeführt sind. Die Stromrichtung ist bei diesen Schaltern horizontal statt vertikal, wie zum Beispiel bei herkömmlichen IGBTs. Die neuen Leistungshalbleiterschalter sind diskrete und lateral aufgebaute Schalter. Diese Leistungshalbleiterbauelemente sind unter anderem in SMD-Bauform und mit einem Löt-Pad auf der Unter- und/oder Oberseite, das als Kontaktfläche zur Kühlfläche wird, verfügbar. Zwar können die gesamten Verluste aufgrund der neuen Technologie reduziert werden, jedoch ist auch die Bauteilgröße klein, wodurch die flächenbezogenen Verlustenergie nach wie vor hoch ist. Hinzu kommt, dass die neuartigen Leistungshalbleiterschalter mit hohen Schaltfrequenzen betrieben werden.

Diese hohen Schaltfrequenzen führen zwar zu höheren Verlusten, jedoch entstehen dadurch neue Vorteile.

Ein Leistungsteil besteht aus mindestens einem Leistungshalbleiterschalter. Dazu kommt, dass mit steigender Miniaturisierung der Bauteile die Leistungshalbleiterschalter immer näher aneinanderrücken und auch bei der elektromagnetischen Verträglichkeit Änderungen am System oftmals notwendig werden.

Heutige Leistungshalbleiter in Antriebsapplikationen sind meist Insulated-Gate-Bipolar-Transistoren (IGBTs). Diese werden in Frequenzumrichtern häufig in ein Modul zusammengefasst. Dabei werden die Leistungshalbleiter auf einem isolierenden Substrat (=DCB (Direct Copper Bonded)) angebracht, wobei die Unterseite des Substrates großflächig Kühlkörper kontaktiert. Um den Wärmeübergang zwischen Modul und Kühlkörper zu verbessern, wird an der Kontaktfläche meist Wärmeleitpaste aufgetragen. Die gesamte Verlustleistung wird hierdurch an einen massiven Kühlkörper abgeführt, welcher im allgemeinen Teil des gesamten Gehäuses ist. Diese Lösung wird besonders von der Systemgrenze des Moduls eingeschränkt, welche bei neuartigen Bauelementen als limitierender Faktor zu sehen ist.

In einer weiteren Lösung können die Halbleiter als SMD-Bauteil auf die Leiterplatte aufgebracht werden. Auf der Leiterplatte werden die Spannungsabstände zwischen den elektrischen Potentialen möglichst klein gewählt, um eine kompakte Baugruppe realisieren zu können. Im Idealfall werden nur die erforderlichen Luft- und Kriechstrecken vorgesehen. Zur Kühlung kann nun die Oberfläche dieser Leiterplatte mit einem Luftstrom gekühlt werden. Der Nachteil dieser Lösung liegt darin, dass durch die Kühlluft die Oberseite dieser Leiterplatte Schmutzpartikeln ausgesetzt ist, die sich an den offenen Pins der Bauelemente ablagern und bei verbinden zweier Potentiale zu einem Kurzschluss führen. Deshalb führt diese Art der Entwärmung zu einer reduzierten Lebensdauer der Baugruppe.

Aufgabe der vorliegenden Erfindung ist es, eine elektronische Baugruppe und ein Verfahren bereitzustellen, mit welchen insbesondere SMD-Leistungshalbleiterschalter gekühlt werden können, ohne die Lebensdauer der elektronischen Baugruppe zu reduzieren.

Diese Aufgabe wird durch eine elektronische Baugruppe und ein Verfahren gemäß den unabhängigen Patentansprüchen gelöst. Sinnvolle Weiterbildungen ergeben sich aus den Unteransprüchen.

Ein Aspekt der Erfindung betrifft eine elektronische Baugruppe mit einer Leiterplatte, welche mit einer ersten und einer zweiten Bestückungsseite ausgebildet ist, und zumindest einen ersten Kühlkörper, welcher auf der ersten Bestückungsseite angeordnet ist. Ebenso sind mehrere elektronische Bauelemente, von denen sich eine Mehrzahl auf der zweiten Bestückungsseite der Leiterplatte befindet, angeordnet. Die elektronische Baugruppe umfasst zumindest eine nicht stromführenden erste Durchkontaktierung der Leiterplatte, mit welcher eine erzeugte thermische Energie des ersten elektronischen Bauelements von der zweiten Bestückungsseite zu der ersten Bestückungsseite transportiert wird. Die elektronische Baugruppe umfasst weiter eine Konvektionseinheit zum Erzeugen einer forcierten Konvektion ausschließlich auf der ersten Bestückungsseite, mit welcher die thermische Energie von der Leiterplatte der elektronischen Baugruppe abtransportierbar ist, sodass eine Entwärmung der elektronischen Baugruppe durchführbar ist. Durch die erzeugte forcierte Konvektion ausschließlich auf der ersten Bestückungsseite kann insbesondere die thermische Energie beziehungsweise die Wärme von der Baugruppe abtransportiert werden. Da die Mehrzahl der elektronischen Bauelemente auf der zweiten Bestückungsseite, welche nicht mit der forcierten Konvektion beaufschlagt wird, angeordnet ist, kann es zu keinerlei beziehungsweise nur zu einer geringen Ansammlung von Schmutzpartikeln an stromführenden Bauteilen kommen. Wegen der geringeren Beaufschlagung mit Schmutzpartikel wird in der Regel die Lebensdauer der Leiterplatte und somit der gesamten elektronischen Baugruppe verlängert, aber vor allem wird die Lebensdauer dadurch nicht verkürzt. Die wenigen elektronischen Bauelemente, welche auf der ersten Bestückungsseite angeordnet werden, können so auf der ersten Bestückungsseite platziert werden, dass diese zueinander einen großen Abstand aufweisen. Dadurch können durch transportierte Schmutzpartikel der forcierten Konvektion keine leitfähigen Verbindungen zwischen den einzelnen elektronischen Bauelementen entstehen und hiermit kann sichergestellt werden, dass die Lebensdauer der elektronischen Baugruppe nicht verringert wird. Insbesondere findet auf der zweiten Bestückungsseite, welche mit einer Mehrzahl der elektronischen Bauelemente ausgebildet ist, eine natürliche Konvektion statt. Die natürliche Konvektion wird durch den natürlichen Luftstrom in der Umgebung der zweiten Bestückungsseite erreicht. Dadurch kann insbesondere ein Teil der erzeugten thermischen Energie von der Leiterplatte abtransportiert werden.

Bei der elektronischen Baugruppe kann es sich beispielsweise um einen DC/DC-Wandler und/oder um einen Frequenzumrichter oder Umrichter handeln. Die Leiterplatte dient als Trennebene zwischen der natürlichen Konvektion auf der zweiten Bestückungsseite und der forcierten Konvektion auf der ersten Bestückungsseite.

Konvektion oder Wärmeströmung soll so zu verstehen sein, dass eine Methode und/oder ein Mechanismus angewendet wird, um einen Wärmeübertrag von Energie von einem Ort zu einem anderen Ort zu erreichen.

Insbesondere weist die erste Bestückungsseite den ersten Kühlkörper auf, welcher die erzeugte thermische Energie in einen Raum der forcierten Konvektion abgeben kann, sodass durch die forcierte Konvektion die thermische Energie abtransportiert werden kann. Die Konvektionseinheit zum Erzeugen der forcierten Konvektion soll möglichst so angeordnet werden, dass der erzeugte Luftstrom durch die forcierte Konvektion ausschließlich auf die erste Bestückungsseite wirkt, ohne dass dieser eine Wirkung auf die zweite Bestückungsseite ausübt. Dadurch soll insbesondere erreicht werden, dass die möglichen Schmutzpartikel ausschließlich auf der ersten Bestückungsseite auftreten, an welcher insbesondere keine stromführenden Bauteile angeordnet werden. Insbesondere kann die thermische Energie beziehungsweise die Wärme von der Leiterplatte der elektronischen Baugruppe mit der forcierten Konvektion oder mit der natürlichen Konvektion abtransportiert werden.

Bei der Konvektionseinheit kann es sich beispielsweise um eine Ventilationseinheit beziehungsweise einen Ventilator, wie etwa einen Lüfter, insbesondere einen Lamellenlüfter, einen Axiallüfter, einen Radialventilator, einen Diagonalventilator, oder einen Querstromventilator handeln. Diese Beispiele sollen nicht abschließend zu verstehen sein, sondern sollen lediglich eine Vielzahl an unterschiedliche Ausführungsformen der Konvektionseinheit darstellen. Insbesondere kann mit der Konvektionseinheit eine künstliche Konvektion erzeugt werden.

Damit die erzeugte thermische Energie durch die insbesondere stromführenden elektronischen Bauelemente der zweiten Bestückungsseite auf die erste Bestückungsseite übertragen werden kann, werden die Durchkontaktierungen dafür verwendet. Bei der Durchkontaktierung kann es sich insbesondere um eine Kupferdurchkontaktierung in der Leiterplatte handeln. Beispielsweise kann die Kupferdurchkontaktierung in der Leiterplatte mit Lötzinn gefüllt sein. Bei den Durchkontaktierungen kann es sich insbesondere um sogenannte Vias handeln. Die Durchkontaktierungen werden dazu verwendet, um die thermische Energie beziehungsweise die Wärme von der zweiten Bestückungsseite an die erste Bestückungsseite zu übertragen. Insbesondere wird mit der ersten Durchkontaktierung eine Wärmeleitung beziehungsweise eine Wärmeübertragung der erzeugten thermischen Energie erreicht. Insbesondere wird die erste Durchkontaktierung benötigt, da die Leiterplatte der elektronischen Baugruppe selbst Wärme schlecht leitet.

Beispielsweise kann es sich bei den elektronischen Bauelementen um Logikschaltungen oder um Stromversorgungsleitungen beziehungsweise Stromversorgungsbahnen oder um Messbauteile oder um Leistungshalbleiterschalter oder um Leistungsschalter oder um IGBTs oder um MOSFETs handeln.

Vorzugsweise ist vorgesehen, dass die mehreren elektronischen Bauelemente und der zumindest erste Kühlkörper basierend auf der Oberflächenmontagetechnik ausgebildet sind. Durch Anwendung der Oberflächenmontagetechnik benötigen die elektronischen Bauelemente keine Drahtanschlüsse, welche durch die Leiterplatte gesteckt werden müssen, sodass die Mehrzahl der elektronischen Bauelemente auf der zweiten Bestückungsseite der Leiterplatte angeordnet werden können und dadurch die Kühlung durch die forcierte Konvektion auf der ersten Bestückungsseite durchgeführt werden kann, sodass die elektronischen Bauteile nicht mit Schmutzpartikeln beaufschlagt werden. Die elektronischen Bauelemente und der zumindest erste Kühlkörper werden mit der SMD-Technologie aufgebaut. Bei der SMD-Technologie werden die SMD-Bauelemente nicht mehr mit Drahtanschlüssen, sondern mittels lötfähiger Anschlussflächen direkt auf der ersten und/oder zweiten Bestückungsseite der Leiterplatte angebracht. Hierzu wird die Oberflächenmontage SMT (Surface-Mount Technology) angewendet. Durch Verwendung von SMD-Bauelementen kann insbesondere ein möglichst platzsparender Aufbau der elektronischen Baugruppe erreicht werden sowie ein geringer thermischer Widerstand zur Leiterplatte garantiert werden. Wegen der immer stetig wachsenden Miniaturisierung der Peripheriebauteile kommt es insbesondere zu immer höheren Packungsdichten und zu einer sich damit verringernden Wärmeabfuhr. Deshalb wird die erzeugte thermische Energie der zweiten Bestückungsseite mithilfe der Durchkontaktierung an die erste Bestückungsseite abtransportiert, sodass durch die forcierte Konvektion der ersten Bestückungsseite die thermische Energie von der elektronischen Baugruppe abgeführt werden kann, sodass die elektronische Baugruppe entwärmt wird.

In einer weiteren vorteilhaften Ausgestaltung der Erfindung ist vorgesehen, dass der zumindest erste Kühlkörper als flächig ausgeführte Leiterbahn oder als ein metallisches Gehäuse oder als metallischer Kühlkörper ausgebildet ist. Um die von der zweiten Bestückungsseite an die erste Bestückungsseite überführte thermische Energie möglichst effizient durch die forcierte Konvektion abführen zu können, wird der zumindest erste Kühlkörper verwendet. Der erste Kühlkörper, welcher insbesondere als SMD-Kühlkörper ausgebildet ist, wird vorzugsweise so an der ersten Bestückungsseite montiert, dass dieser auf der gegenüberliegenden Seite im Wärmepfad der elektronischen Bauelemente, welche die thermische Energie erzeugen, angeordnet ist. Je nach zur Verfügung stehender Fläche auf der elektronischen Baugruppe beziehungsweise auf der Leiterplatte kann der Kühlkörper als flächige Leiterbahn oder als Kupferflachband ausgebildet sein, wodurch möglichst wenig Bauraum benötigt wird. Um möglichst viel thermische Energie abgeben zu können, kann der Kühlkörper als metallisches Gehäuse ausgebildet sein, welches vorzugsweise aus Kupfer oder Aluminium ausgebildet ist. Somit kann thermische Energie durch die forcierte Konvektion von der Leiterplatte abtransportiert werden.

In einer vorteilhaften Ausgestaltung ist vorgesehen, dass die erste Durchkontaktierung parallel zu mindestens einer zweiten Durchkontaktierung der Leiterplatte nebeneinander angeordnet ist. Um eine möglichst gute Wärmeleitung der thermisch erzeugten Energie von der zweiten Bestückungsseite an die erste Bestückungsseite erreichen zu können werden mehrere, insbesondere die erste und die zweite Durchkontaktierung, nebeneinander parallel angeordnet. Vorzugsweise können ebenso mehrere Durchkontaktierungen parallel nebeneinander angeordnet werden. Je mehr Durchkontaktierungen parallel zueinander angeordnet werden, desto besser kann die thermische Energie von der zweiten Bestückungsseite an die erste Bestückungsseite abgegeben werden. Je besser die thermische Energie von der zweiten Bestückungsseite an die erste Bestückungsseite überführt werden kann, desto mehr kann die Lebensdauer der elektronischen Baugruppe erhöht werden. Beispielsweise können die erste Durchkontaktierung und die zweite Durchkontaktierung so angeordnet werden, dass sie zueinander parallel sind und an einem Bauteil der mehreren Bauelemente angeordnet sind.

Vorzugsweise ist vorgesehen, dass die erste Durchkontaktierung und/oder die zweite Durchkontaktierung isoliert von elektrischen Leiterbahnen oder auch verbunden mit elektrischen Leiterbahnen gleichen Potentiales auf der Leiterplatte möglichst nah an einem oder einer Gruppe der mehreren elektronischen Bauelemente angeordnet sind. Um eine möglichst gute Entwärmung der elektronischen Bauelemente zu erreichen sollen die erste Durchkontaktierung und/oder die zweite Durchkontaktierung so nah wie möglich unter Einhaltung elektrischer und mechanischer Gegebenheiten an einem oder an einer Gruppe von elektronischen Bauelementen angeordnet werden. Dadurch kann die thermische Energie, welche durch die elektronischen Bauelemente erzeugt wird, mit der ersten und/oder der zweiten Durchkontaktierung von der zweiten Bestückungsseite an die erste Bestückungsseite übertragen werden. Somit kann die thermische Energie möglichst effizient durch die forcierte Konvektion auf die erste Bestückungsseite transportiert werden.

Die Anordnung der ersten Durchkontaktierung und der zweiten Durchkontaktierung ist von spezifischen Bedingungen oder Normen bei der Herstellung der Leiterplatte der elektronischen Baugruppe abhängig. Die erste und/oder die zweite Durchkontaktierung kann in bestimmten Fällen nur so nahe an dem elektronischen Bauelement angeordnet werden, dass bestimmte Isolationsabstände zwischen der Durchkontaktierung und dem elektronischen Bauelement eingehalten werden können. Die elektronischen Bauelemente und die Durchkontaktierung sollen auch so angeordnet werden, dass diese zur stromführenden Leiterbahn genügend Abstand besitzen, sodass es zu keinerlei Überschlägen kommen kann. Insbesondere kann bei der Anordnung der ersten Durchkontaktierung und der zweiten Durchkontaktierung an den elektronischen Bauelementen der DRC (Design-Rule-Check) und der ERC (Electrical-Rule-Check) angewendet werden. Diese werden vor allem bei der Layouterstellung der Leiterplatte für die Layoutverifikation angewendet. Die Anordnung der ersten und/oder der zweiten Durchkontaktierung soll so möglichst nah an der elektronischen Baueinheit angeordnet werden, dass zum einen die Normen und Bedingungen für die Layouterstellung der Leiterplatte gewährleistet werden und ebenso die erzeugte thermische Energie gut abführbar ist. Insbesondere müssen bei der Anordnung der ersten Durchkontaktierung und bei der zweiten Durchkontaktierung an die elektronischen Bauelemente ebenfalls Aspekte der elektromagnetischen Verträglichkeit berücksichtigt werden.

Vorzugsweise ist vorgesehen, dass die erste Durchkontaktierung zur Stromführung ausgebildet ist und auf der zweiten Bestückungsseite der Leiterplatte mit einer elektrisch isolierenden Schicht beschichtet ist, wohingegen die zweite Durchkontaktierung nicht stromführend ausgebildet ist und gegebenenfalls nicht mit der elektrisch isolierenden Schicht beschichtet ist. Beispielsweise kann die isolierende Schicht als Interface-Material zwischen dem Kühlkörper und der Leiterplatte ausgebildet sein. Insbesondere kann die erste Durchkontaktierung und/oder die zweite Durchkontaktierung primär für die Wärmeübertragung der thermischen Energie von der zweiten Bestückungsseite an die erste Bestückungsseite verwendet werden. Ebenso kann aber auch die erste Durchkontaktierung zur Stromführung ausgebildet werden und beispielsweise verschiedene elektronische Bauelemente mit Strom versorgen. Da die erste Durchkontaktierung und die zweite Durchkontaktierung räumlich ohne großen Abstand zueinander angeordnet sein können und die erste Durchkontaktierung und die zweite Durchkontaktierung auf unterschiedlichen Potentialen liegen können, kann es im Störfall zu einem Kurzschluss kommen. Damit verhindert werden kann, dass es zu einem Kurzschluss zwischen der ersten Durchkontaktierung und der zweiten Durchkontaktierung oder zwischen der ersten Durchkontaktierung und/oder der zweiten Durchkontaktierung zu einem anderen elektronischen Bauelement kommt, wird insbesondere die stromführende erste Durchkontaktierung mit einer elektrisch isolierenden Schicht beschichtet. Diese elektrisch isolierende Schicht sorgt dafür, dass es zu keinem Kurzschluss zwischen der ersten Durchkontaktierung und der zweiten Durchkontaktierung auf der ersten Bestückungsseite kommen kann. Insbesondere erfolgt die Beschichtung mit der isolierenden Schicht nur auf der Seite der Durchkontaktierung, welche an der ersten Bestückungsseite anliegt. Insbesondere soll die zweite Durchkontaktierung, welche nicht stromführend ist, sondern für die Wärmeübertragung der thermischen Energie ausgebildet ist, nicht mit der elektrisch isolierenden Schicht beschichtet sein. Die zweite Durchkontaktierung ist deshalb nicht mit der Schicht beschichtet, weil die elektrisch isolierende Schicht zwar eine gute elektrische Isolierung gewährleistet, aber eine schlechte beziehungsweise eine Verschlechterung der Wärmeübertragung bewirkt. Dadurch kann im Ernstfall nicht genügend Wärme von dem elektronischen Bauelement abtransportiert werden.

In einer vorteilhaften Ausgestaltung der Erfindung ist vorgesehen, dass die elektrisch isolierende Schicht als Isolierfolie oder als Isolierlack ausgebildet ist. Um insbesondere die wärmeführenden Durchkontaktierungen vor einem elektrischen Überschlag schützen zu können, werden die stromführenden Durchkontaktierungen mit einer elektrisch isolierenden Schicht beschichtet, wobei die elektrisch isolierende Schicht vorzugsweise als Isolierfolie oder als Isolierlack ausgebildet ist. Die Isolierfolie kann insbesondere verwendet werden, wenn beispielsweise die komplette beziehungsweise nur Teilbereiche der ersten Bestückungsseite mit der isolierenden Schicht beschichtet werden soll. Die Isolierfolie kann effizient auf die gesamte erste Bestückungsseite angebracht werden. Hingegen hat der Isolierlack den Vorteil, dass nur die Durchkontaktierungen, welche für die Stromführung ausgebildet sind, gezielt mit der isolierenden Schicht beschichtet werden können.

In einer weiteren Ausgestaltung ist vorgesehen, dass dem ersten elektronischen Bauelement der erste Kühlkörper zugeordnet ist, und/oder einem zweiten elektronischen Bauelement, welches auf der ersten Bestückungsseite und auf der zweiten Bestückungsseite angeordnet ist, ein zweiter Kühlkörper auf der ersten Bestückungsseite zugeordnet ist, und/oder dem ersten elektronischen Bauelement und dem zweiten elektronischen Bauelement und/oder der zweite Kühlkörper zugeordnet ist. Um eine möglichst effiziente Entwärmung der Leiterplatte beziehungsweise der elektronischen Baugruppe zu erreichen, kann beispielsweise jedem elektronischen Bauelement, insbesondere jedem Leistungshalbleiterschalter, ein Kühlkörper auf der ersten Bestückungsseite zugeordnet werden. Insbesondere wird der erste Kühlkörper so angeordnet, dass dieser gegenüber dem ersten elektronischen Bauelement angeordnet ist. Ebenso kann der zweite Kühlkörper so auf der ersten Bestückungsseite angeordnet werden, dass dieser gegenüber dem zweiten elektronischen Bauelement platziert ist. Beispielsweise kann dem ersten elektronischen Bauelement und dem zweiten elektronischen Bauelement ein und derselbe Kühlkörper zugeordnet werden, sodass insbesondere auf der ersten Bestückungsseite die Kühlkörper platzsparend angeordnet werden können und je nach Platzbedarf dabei bei der Anzahl an Kühlkörpern Einsparungen vorgenommen werden. Insbesondere kann es ebenso möglich sein, dass das erste elektronische Bauelement, bei welchem es sich um einen Leistungshalbleiter handelt, auf der ersten Bestückungsseite angeordnet ist, wobei der erste Kühlkörper direkt auf dem ersten elektronischen Bauelement auf der ersten Bestückungsseite angeordnet ist. Dadurch kann eine entstehende thermische Energie optimal abgeführt werden und mit dem Luftstrom der forcierten Konvektion abtransportiert werden. Beispielsweise kann die erste oder der zweite Kühlkörper als flächig ausgeführte Leiterbahn ausgebildet sein, sodass mit dieser flächigen Leiterbahn sowohl das erste elektronische Bauelement und das zweite elektronische Bauelement gekühlt werden können.

Vorzugsweise ist vorgesehen, dass für einen ersten Kühlkörper ein erstes Potential bereitgestellt ist und für den zweiten Kühlkörper ein vom ersten Potential verschiedenes zweites Potential bereitgestellt ist, oder der erste Kühlkörper und der zweite Kühlkörper mit dem ersten Potential oder mit dem zweiten Potential verbunden sind. Insbesondere kann mit SMD-Kühlkörpern, welche auf einem bestimmten Potential liegen, neue Freiheiten im Aufbau der elektronischen Baugruppe erreicht werden. Dies kann zu kleineren Abmessungen der elektronischen Baugruppe führen und zu einer Leistungserhöhung der elektronischen Baugruppe. Dadurch, dass dem ersten Kühlkörper das erste Potential und dem zweiten Kühlkörper das zweite Potential bereitgestellt wird, kann auf einen großen, auf Erdpotential liegenden Kühlkörper verzichtet werden, wobei dadurch zum Beispiel die Normeinhaltung der elektromagnetischen Verträglichkeit für die erhöhten Schaltfrequenzen auf der elektronischen Baugruppe verbessert werden kann. Durch Verwendung unterschiedlicher Potentiale können parasitäre Kapazitäten von der elektronischen Baugruppe zum ersten und/oder zum zweiten Kühlkörper wegfallen. Insbesondere muss es sich bei dem ersten und/oder bei dem zweiten Potential nicht zwingend um das Erdpotential handeln, sondern es kann jeweils ein beliebiges festes oder springendes Potential sein. Das erste und/oder das zweite Potential des ersten und/oder des zweiten Kühlkörpers sind jeweils unabhängig voneinander und können sich von dem jeweils anderen Potential unterscheiden. Dadurch können Aspekten der elektromagnetischen Verträglichkeit bei der Erstellung der elektronischen Baugruppe besser Rechnung getragen werden.

Ein weiterer Aspekt der Erfindung betrifft ein Verfahren zum Entwärmen einer elektronischen Baugruppe, welche eine Leiterplatte mit einer ersten oder einer zweiten Bestückungsseite aufweist. Die zweite Bestückungsseite kann mit einer natürlichen Konvektion entwärmt werden und eine thermische Energie kann von der zweiten Bestückungsseite mit einer Durchkontaktierung in der Leiterplatte zu der ersten Bestückungsseite transportiert werden. Mit einer forcierten Konvektion auf der ersten Bestückungsseite kann die thermische Energie von der Leiterplatte abtransportiert werden, sodass die elektronische Baugruppe entwärmt wird. Bei der natürlichen Konvektion handelt es sich um die natürliche Luftströmung, welche die zweite Bestückungsseite, insbesondere die elektronischen Bauteile auf der zweiten Bestückungsseite, kühlen kann. Die thermische Energie, welche insbesondere von elektronischen Bauelementen auf der zweiten Bestückungsseite erzeugt wird, kann durch Durchkontaktierungen, insbesondere Kupferdurchkontaktierungen, in der Leiterplatte von der zweiten Bestückungsseite an die erste Bestückungsseite der Leiterplatte transportiert werden. Damit die thermische Energie von der zweiten Bestückungsseite auf der ersten Bestückungsseite weg von der Leiterplatte transportiert werden kann, wird die erste Bestückungsseite mit einer forcierten Konvektion versehen. Die forcierte Konvektion wird insbesondere durch eine Konvektionseinheit erzeugt. Insbesondere entsteht durch die Konvektionseinheit ein Luftstrom, welcher die thermische Energie beziehungsweise die Wärme von der ersten Bestückungsseite abtransportiert, sodass insbesondere die Leiterplatte der elektronischen Baugruppe gekühlt werden kann.

Ein unabhängiger Aspekt der Erfindung betrifft eine elektronische Baugruppe mit einer Leiterplatte, welche mit einer ersten Bestückungsseite und einer zweiten Bestückungsseite ausgebildet ist. Insbesondere umfasst die Leiterplatte zumindest einen ersten Kühlkörper, welcher auf der ersten Bestückungsseite angeordnet ist, und mehreren elektronischen Bauelementen, von denen eine Mehrzahl auf der zweiten Bestückungsseite der Leiterplatte angeordnet ist. Weiter umfasst die Leiterplatt der elektronischen Baugruppe transportierbar ist. Die Leiterplatte umfasst beispielsweise einen Kühlkörper, welcher als ein metallisches Gehäuse ausgebildet ist und welcher auf der ersten Bestückungsseite angeordnet ist Ebenfalls kann die Leiterplatte eine Konvektionseinheit zum Erzeugen einer forcierten Konvektion ausschließlich auf der ersten Bestückungsseite umfassen, mit welcher die thermische Energie von der Leiterplatte der elektronischen Baugruppe abtransportierbar ist, sodass eine Entwärmung der elektronischen Baugruppe (1) durchführbar ist.

Ein weiterer unabhängiger Aspekt der Erfindung betrifft ein Verfahren zum Entwärmen einer elektronischen Baugruppe, welche eine Leiterplatte mit einer ersten Bestückungsseite und einer zweiten Bestückungsseite aufweist, wobei die zweite Bestückungsseite mit einer natürlichen Konvektion entwärmt wird. Insbesondere wird eine thermische Energie von der zweiten Bestückungsseite mit einer stromführenden Durchkontaktierung in der Leiterplatte zu der ersten Bestückungsseite und in einen Kühlkörper transportiert. Mit einer forcierten Konvektion auf der ersten Bestückungsseite wird insbesondere die thermische Energie von der Leiterplatte und/oder von dem Kühlkörper abtransportiert, sodass die elektronische Baugruppe entwärmt wird.

Die für die erfindungsgemäße elektronische Baugruppe angegebenen Vorteile und Wirkungen gelten natürlich gleichermaßen für das erfindungsgemäße Verfahren und umgekehrt. Infolgedessen können Vorrichtungsmerkmale natürlich auch als Verfahrensmerkmale und umgekehrt formuliert sein.

Weitere Vorteile und Merkmale ergeben sich aus der folgenden Beschreibung von Ausführungsbeispielen anhand der Figuren. In den Figuren bezeichnen gleiche Bezugszeichen gleiche Merkmale und Funktionen.

Es zeigen:
- FIG 1: eine schematische Darstellung der elektronischen Baugruppe mit einer Leiterplatte, welche eine erste und eine zweite Bestückungsseite umfasst;
- FIG 2: eine weitere schematische Darstellung der elektronischen Baugruppe mit einer Leiterplatte, wobei sich hier ein Kühlkörper und ein elektronisches Bauelement auf einer ersten Bestückungsseite der Leiterplatte befinden; und
- FIG 3: eine weitere schematische elektronische Baugruppe mit einer Leiterplatte, wobei hier die Kühlkörper auf unterschiedlichen Potentialen liegen.

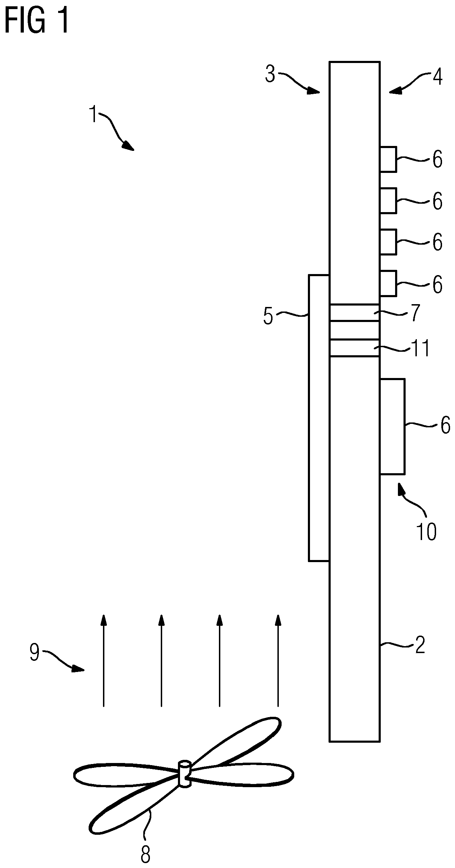

Die FIG 1 zeigt eine schematische Darstellung der elektronischen Baugruppe 1 mit einer Leiterplatte 2, welche mit einer ersten Bestückungsseite 3 und einer zweiten Bestückungsseite 4 ausgebildet ist. Insbesondere umfasst die erste Bestückungsseite 3 der Leiterplatte 2 einen ersten Kühlkörper 5. Die Leiterplatte 2 der elektronischen Baugruppe 1 umfasst beispielsweise mehrere elektronische Bauelemente 6, von denen eine Mehrzahl auf der zweiten Bestückungsseite 4 der Leiterplatte 2 angeordnet ist. Die Leiterplatte 2 umfasst insbesondere eine erste nicht stromführenden Durchkontaktierung 7, mit welcher eine erzeugte thermische Energie eines elektronischen Bauelements 6 von der zweiten Bestückungsseite 4 zu der ersten Bestückungsseite 3 transportiert werden kann. Die elektronische Baugruppe 1 umfasst insbesondere eine Konvektionseinheit 8, mit welcher eine forcierte Konvektion 9 erzeugt werden kann. Die forcierte Konvektion 9 wird ausschließlich auf der ersten Bestückungsseite 3 der Leiterplatte 2 erzeugt, mit welcher die thermische Energie von der Leiterplatte 2 der elektronischen Baugruppe 1 abtransportierbar ist, sodass ein Entwärmen der elektronischen Baugruppe 1 durchgeführt werden kann. Mit der forcierten Konvektion 9 kann insbesondere ein Luftstrom erzeugt werden, welcher ausschließlich die thermische Energie beziehungsweise Wärme auf der ersten Bestückungsseite 3 der Leiterplatte 2 abtransportiert. Die zweite Bestückungsseite 4 kann beispielsweise eine natürliche Konvektion aufweisen, welche durch einen natürlichen Luftstrom erreicht werden kann. Dadurch kann insbesondere ein Teil der erzeugten thermischen Energie bereits abgeführt werden, sodass insbesondere die elektronischen Bauelemente 6 entwärmt werden können.

Bei der ersten Durchkontaktierung 7 kann es sich insbesondere um eine Kupferdurchkontaktierung handeln, welche beispielsweise mit Lötzinn gefüllt ist. Mit der ersten Durchkontaktierung kann die thermische Energie der zweiten Bestückungsseite 4 an insbesondere den Kühlkörper 5 der ersten Bestückungsseite 3 überführt werden. Der erste Kühlkörper 5 kann sodann mithilfe der forcierten Konvektion 9 die thermische Energie von der Leiterplatte 2 abtransportieren, sodass die elektronische Baugruppe 1 gekühlt werden kann.

Beispielsweise können die elektronischen Bauelemente 6 und der erste Kühlkörper 5 als SMD-Bauteile ausgebildet sein. Mithilfe der SMD-Technologie kann insbesondere eine Miniaturisierung der elektronischen Baugruppe 1 erreicht werden. Durch Verwendung von SMD-Bauteilen können insbesondere die elektronischen Bauelemente 6 platzsparend auf der zweiten Bestückungsseite 4 montiert werden.

Bei der elektronischen Baugruppe 1 kann es sich beispielsweise um einen Umrichter beziehungsweise Frequenzumrichter handeln. Insbesondere können die elektronischen Bauelemente 6 Logikschaltungen, stromführende Bauteile, Messleitungen, Leiterbahnen, IGBTs oder MOSFETs sein. Insbesondere kann die elektronische Baugruppe 1 einen Leistungshalbleiterschalter 10 als elektronisches Bauelement 6 aufweisen. Die Beispiele der elektronischen Bauelemente 6 sollen nicht abschließend zu verstehen sein, sondern sollen nur die Vielzahl an möglichen elektronischen Bauelementen 6 darstellen.

Beispielsweise kann der erste Kühlkörper 5 als flächig ausgeführte Leiterbahn beziehungsweise flächig ausgeführte Leitfläche ausgebildet sein. Beispielsweise kann ebenso der erste Kühlkörper 5 als ein metallisches Gehäuse ausgebildet sein, wobei das Gehäuse des ersten Kühlkörpers 5 beispielsweise aus Kupfer oder Aluminium ausgebildet sein kann.

Beispielsweise kann die erste Durchkontaktierung 7 parallel zumindest einer zweiten Durchkontaktierung 11 der Leiterplatte 2 nebeneinander angeordnet werden. Durch das parallele Anordnen von der ersten Durchkontaktierung 7 und der zweiten Durchkontaktierung 11 auf der Leiterplatte 2 kann eine verbesserte Wärmeüberführung der thermischen Energie von der zweiten Bestückungsseite 4 an die erste Bestückungsseite 3 erreicht werden. Insbesondere kann die erste Durchkontaktierung 7 und/oder die zweite Durchkontaktierung 11 isoliert von den elektrischen Leiterbahnen auf der Leiterplatte 2 möglichst nahe an einem oder an einer Gruppe der mehreren elektronischen Bauelemente 6 angeordnet werden. Insbesondere sollen zwar die erste Durchkontaktierung 7 und/oder die zweite Durchkontaktierung 11 so nah wie möglich an einem der elektronischen Bauelemente 6 angeordnet werden, aber dabei müssen bestimmte Kriterien und/oder Normen bei dem Layout der Leiterplatte 2 berücksichtigt werden. Dabei sind insbesondere Isolationsabstände zwischen der ersten Durchkontaktierung 7 und/oder der zweiten Durchkontaktierung 11 mit dem elektronischen Bauelement 6 oder mit einer Leiterbahn auf der Leiterplatte 2 zu beachten. Ebenso müssen bei der Anordnung der ersten Durchkontaktierung 7 oder der zweiten Durchkontaktierung 11 Aspekte der elektromagnetischen Verträglichkeit der elektronischen Baugruppe 1 mitberücksichtigt werden. Unter Berücksichtigung der soeben gekannten Kriterien sollen die erste Durchkontaktierung 7 und die zweite Durchkontaktierung 11 so nah wie möglich an einem der elektronischen Bauelemente 6 angeordnet werden, sodass zum einen die Kriterien eingehalten werden können und zum anderen eine effiziente Wärmeabfuhr der erzeugten thermischen Energie an die erste Bestückungsseite 3 durchgeführt werden kann. Beispielsweise kann in manchen Fällen auch die erste Durchkontaktierung 7 und/oder die zweite Durchkontaktierung 11 direkt unter dem elektrischen Bauelement 6 sein, um die thermische Wärmeabfuhr zu verbessern.

Beispielsweise kann die erste Durchkontaktierung 7 zur Stromführung auf der Leiterplatte 2 verwendet werden, wobei dabei insbesondere der Bereich der ersten Durchkontaktierung 7, welcher sich auf der ersten Bestückungsseite 3 der Leiterplatte 2 befindet, mit einer elektrisch isolierten Schicht beschichtet werden kann. Hingegen wird die zweite Durchkontaktierung 11, welche nicht zur Stromführung ausgebildet ist, sondern zum Abtransport der erzeugten thermischen Energie ausgebildet ist, nicht mit der elektrisch isolierenden Schicht beschichtet. Mit der elektrisch isolierenden Schicht wird verhindert, dass es zwischen der ersten Durchkontaktierung 7 und der zweiten Durchkontaktierung 11 zu einem elektrischen Überschlag oder zu einem Kurzschluss kommen kann. Bei der elektrisch isolierenden Schicht kann es sich beispielsweise um eine Isolierfolie oder um einen Isolierlack handeln. Beispielsweise kann nicht nur die stromführende erste Durchkontaktierung 7 beschichtet sein, sondern es kann ebenso ein Teil oder die komplette Fläche der ersten Bestückungsseite 3 mit der isolierten Schicht beschichtet werden.

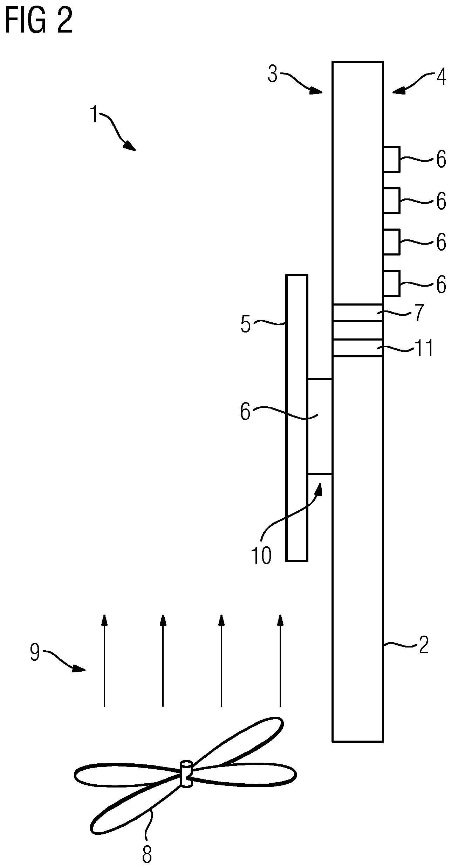

Die FIG 2 zeigt eine weitere schematische Darstellung der elektronischen Baugruppe 1 mit der Leiterplatte 2, wobei sich in diesem Beispiel der erste Kühlkörper 5 und der Leistungshalbleiterschalter 10 als elektronisches Bauelement 6 auf der ersten Bestückungsseite 3 der Leiterplatte 2 befinden. Dabei ist der erste Kühlkörper 5 auf der ersten Bestückungsseite 3 dem Leistungshalbleiterschalter 10 zugeordnet. Dadurch kann die erzeugte thermische Energie des Leistungshalbleiterschalters 10 mithilfe des Kühlkörpers 5 durch die von der Konvektionseinheit 8 erzeugte forcierte Konvektion 9 gekühlt werden. Insbesondere ergibt sich hierbei eine verbesserte Wärmeabführung der erzeugten thermischen Energie. Beispielsweise kann der Leistungshalbleiterschalter 10 nur Pins auf der Unterseite des Leistungshalbleiterschalters 10 aufweisen, wobei die Pins untereinander einen genügend großen Abstand zueinander besitzen. Um den Leistungshalbleiterschalter 10 vor einem Kurzschluss oder einem Überschlag schützen zu können, können die Pins des Leistungshalbleiterschalters 10 mit der elektrisch isolierenden Schicht beschichtet werden. Wenn beispielsweise die Pins des Leistungshalbleiterschalters 10 mit der Schicht beschichtet werden, muss nicht der erste Kühlkörper 5 oder die erste Bestückungsseite 3 der Leiterplatte 2 selbst beschichtet werden. Auf der zweiten Bestückungsseite 4 der Leiterplatte 2 befinden sich in diesem Beispiel beispielsweise Logikschaltungen, welche ebenso thermische Energie erzeugen, die insbesondere durch die erste Durchkontaktierung 7 und/oder die zweite Durchkontaktierung 11 von der zweiten Bestückungsseite 4 an die erste Bestückungsseite 3 überführt wird. Mit der forcierten Konvektion 9 kann anschließend die thermische Energie von der Leiterplatte 2 abtransportiert werden, sodass die Leiterplatte 2 und insbesondere die elektronische Baugruppe 1 gekühlt werden kann.

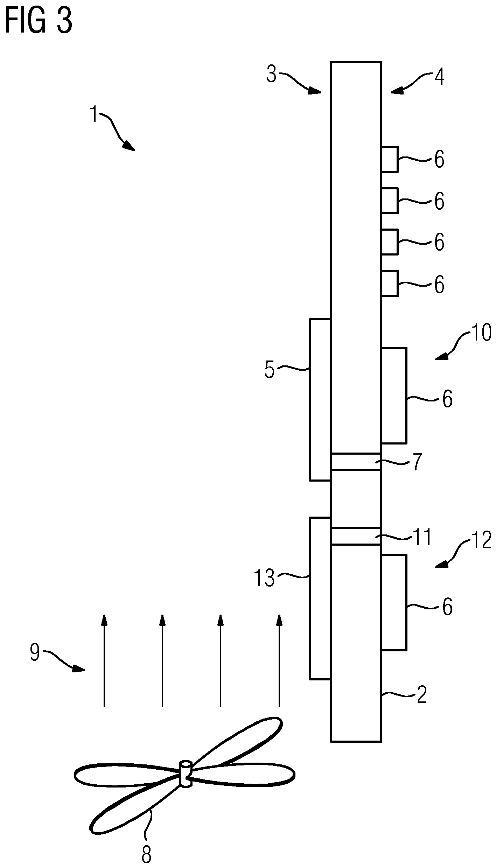

Die FIG 3 zeigt eine weitere schematische Darstellung der elektronischen Baugruppe 1 mit der Leiterplatte 2, wobei in diesem Beispiel der erste Kühlkörper 5 dem ersten elektronischen Bauelement 10 zugeordnet werden kann und ein zweiter Kühlkörper 13 einem weiteren Leistungshalbleiterschalter 12 zugeordnet werden kann. In diesem Beispiel befindet sich der erste Kühlkörper 5 und der zweite Kühlkörper 13 auf der ersten Bestückungsseite 3 der Leiterplatte 2 und der Leistungshalbleiterschalter 10 und der weitere Leistungshalbleiterschalter 12 befinden sich auf der zweiten Bestückungsseite 4 der Leiterplatte 2. Beispielsweise kann der erste Kühlkörper 5 einem ersten Potential zugeordnet werden und der zweite Kühlkörper 13 einem vom ersten Potential unterschiedlichen zweiten Potential zugeordnet werden. Beispielsweise kann es auch vorgesehen sein, dass der erste Kühlkörper 5 und der zweite Kühlkörper 13 entweder auf dem ersten Potential oder auf dem zweiten Potential zusammen verbunden werden.

Insbesondere kann der Leistungshalbleiterschalter 10 dem ersten Kühlkörper 5 zugeordnet werden. Dabei befinden sich der erste Kühlkörper 5 und der Leistungshalbleiterschalter 10 gegenüberliegend. Der weitere Leistungshalbleiterschalter 12 kann genauso dem zweiten Kühlkörper gegenüberliegend angeordnet sein. Beispielsweise kann für den Leistungshalbleiterschalter 10 und den weiteren Leistungshalbleiterschalter 12 nur entweder der erste Kühlkörper 5 und/oder der zweite Kühlkörper 13 zugeordnet werden. Dabei kann beispielsweise der erste Kühlkörper 5 oder der zweite Kühlkörper 13 als flächige Leiterbahn ausgebildet sein. Das erste und/oder das zweite Potential müssen nicht zwingend das Erdpotential sein, sondern bei dem ersten und/oder dem zweiten Potential kann es sich um ein beliebig festes oder springendes Potential handeln.

Durch Zuordnung eines separaten Kühlkörpers 5, 13 für jeden Leistungshalbleiterschalter 10, 12 kann die Wärmeabfuhr der erzeugten thermischen Energie optimal verbessert werden, sodass die Wärme durch die forcierte Konvektion 9 auf der ersten Bestückungsseite 3 abtransportiert werden kann. Beispielsweise kann die erste Durchkontaktierung 7 dem Leistungshalbleiterschalter 10 zur Verfügung gestellt werden und die zweite Durchkontaktierung 11 kann dem weiteren Leistungshalbleiterschalter 12 zugeordnet werden. Dadurch kann erreicht werden, dass die Leiterplatte 2 und insbesondere die elektronische Baugruppe 1 optimal gekühlt werden kann.

## Patentansprüche

1. Elektronische Baugruppe (1) mit,
- einer Leiterplatte (2), welche mit einer ersten Bestückungsseite (3) und einer zweiten Bestückungsseite (4) ausgebildet ist,
- zumindest einem ersten Kühlkörper (5), welcher auf der ersten Bestückungsseite (3) angeordnet ist, und
- mehreren elektronischen Bauelementen (6), von denen eine Mehrzahl auf der zweiten Bestückungsseite (4) der Leiterplatte (2) angeordnet ist,
- zumindest einer nicht stromführenden ersten Durchkontaktierung (7) in der Leiterplatte (2), mit welcher eine erzeugte thermische Energie eines elektronischen Bauelements (6) von der zweiten Bestückungsseite (4) zu der ersten Bestückungsseite (3) transportierbar ist, und
- einer Konvektionseinheit (8) zum Erzeugen einer forcierten Konvektion (9) ausschließlich auf der ersten Bestückungsseite (3), mit welcher die thermische Energie von der Leiterplatte (2) der elektronischen Baugruppe (1) abtransportierbar ist, sodass eine Entwärmung der elektronischen Baugruppe (1) durchführbar ist.

2. Elektronische Baugruppe (1) nach einer der vorhergehenden Ansprüche, **dadurch gekennzeichnet, dass** die mehreren elektronischen Bauelemente (6) und der zumindest erste Kühlkörper (5) basierend auf der Oberflächenmontagetechnik ausgebildet sind.

3. Elektronische Baugruppe (1) nach einem der vorhergehenden Ansprüche, **dadurch gekennzeichnet, dass** der zumindest erste Kühlkörper (5) als flächig ausgeführte Leiterbahn oder als ein metallisches Gehäuse ausgebildet ist.

4. Elektronische Baugruppe (1) nach einem der vorhergehenden Ansprüche, **dadurch gekennzeichnet, dass** die erste Durchkontaktierung (7) parallel zu zumindest einer zweiten Durchkontaktierung (11) der Leiterplatte (2) nebeneinander angeordnet ist.

5. Elektronische Baugruppe (1) nach Anspruch 4, **dadurch gekennzeichnet, dass** die erste Durchkontaktierung (7) und/oder die zweite Durchkontaktierung (11) isoliert von elektrischen Leiterbahnen auf der Leiterplatte (2) möglichst nahe an einem oder an einer Gruppe der mehreren elektronischen Bauelemente (6) angeordnet ist.

6. Elektronische Baugruppe (1) nach Anspruch 4 oder 5, **dadurch gekennzeichnet, dass** die erste Durchkontaktierung (7) zur Stromführung ausgebildet ist und auf der ersten Bestückungsseite (3) der Leiterplatte (2) mit einer elektrisch isolierenden Schicht beschichtet ist, wohingegen die zweite Durchkontaktierung (11) nicht stromführend ausgebildet ist und gegebenenfalls nicht mit der elektrisch isolierenden Schicht beschichtet ist.

7. Elektronische Baugruppe (1) nach Anspruch 6, **dadurch gekennzeichnet, dass** die elektrisch isolierende Schicht als Isolierfolie oder als Isolierlack ausgebildet ist.

8. Elektronische Baugruppe (1) nach einem der vorhergehenden Ansprüche, **dadurch gekennzeichnet, dass** einem ersten elektronischen Bauelement (10) der erste Kühlkörper (5) zugeordnet ist, und/oder einem zweiten elektronischen Bauelement (12), welches auf der ersten Bestückungsseite (3) oder auf der zweiten Bestückungsseite (4) angeordnet ist, ein zweiter Kühlkörper (13) auf der ersten Bestückungsseite (3) zugeordnet ist, und/oder dem ersten elektronischen
Bauelement (10) und dem zweiten elektronischen Bauelement (12) der erste Kühlkörper (5) oder der zweiten Kühlkörper (13) zugeordnet sind.

9. Elektronische Baugruppe (1) nach Anspruch 8, **dadurch gekennzeichnet, dass** für den ersten Kühlkörper (5) ein erstes Potential bereitgestellt ist und für den zweite Kühlkörper (13) ein vom ersten Potential verschiedenes zweites Potential bereitgestellt ist, oder der erste Kühlkörper (5) und der zweite Kühlkörper (13) mit dem ersten Potential oder mit dem zweiten Potential verbunden sind.

10. Verfahren zum Entwärmen einer elektronischen Baugruppe (1), welche eine Leiterplatte (2) mit einer ersten Bestückungsseite (3) und einer zweiten Bestückungsseite (4) aufweist, wobei
- die zweite Bestückungsseite (4) mit einer natürlichen Konvektion entwärmt wird, und
- eine thermischen Energie von der zweiten Bestückungsseite (4) mit einer nicht stromführenden Durchkontaktierung (7, 11) in der Leiterplatte (2) zu der ersten Bestückungsseite (3) transportiert wird, und
- mit einer forcierten Konvektion (9) auf der ersten Bestückungsseite (3) die thermische Energie von der Leiterplatte (2) abtransportiert wird, sodass die elektronische Baugruppe (1) entwärmt wird.
